# EUROPEAN PATENT APPLICATION

(11) **EP 1 900 685 A1**
(43) Date of publication of application: **19.03.2008**
(21) Application number: 07120115.6
(22) Date of filing: 10.11.2005
(51) Int. Cl.: C01B 33/02

(54) **Dust-free granular silicon composition**

(30) Priority: 12.11.2004 US 988179
(62) Divisional of application: 05851459.7
(71) Applicant: MEMC Electronic Materials, Inc., St. Peters, Missouri 63376 (US)
(72) Inventor: IBRAHIM, Jameel, Pasadena, TX 77501-2012 (US); IVEY, Melinda Gayle, Pasadena, TX 77501-2012 (US); TRUONG, Timothy Dinh, Pasadena, TX 77501-2012 (US)
(74) Representative: Smaggasgale, Gillian Helen

(57) **Abstract**

A granular silicon composition comprises a plurality of free-flowing silicon particles having a total weight of at least about 300 kg. At least 99 percent of the particles are between about 250 and about 3500 microns in size so that dust in minimized. This attribute of the granular silicon facilitates use of the granular silicon in the commercial production of semiconductor materials, such as in a Czochralski crystal puller.

## Description

### FIELD OF INVENTION

This invention relates to a high-purity dust-free granular silicon for use in the semiconductor industry.

### BACKGROUND

Most single-crystal silicon used in the semiconductor industry is prepared by the Czochralski ("Cz") process. In this process, a single-crystal silicon ingot is produced by melting high purity polysilicon in a crucible, dipping a seed crystal into the silicon melt, and slowly raising the seed crystal as molten silicon solidifies at the crystal-melt interface in single crystal form. Granular silicon offers certain advantages over chunk silicon as a source of high purity silicon to be melted in the crucible. For example, granular silicon is less likely to damage the crucible, takes less time to load into a crucible, and can be used to recharge the crucible with silicon during the crystal growing process. These and other advantages of granular silicon are described in more detail in co-assigned U.S. Patent No. 5,919,303, the disclosure of which is hereby incorporated by reference.

Granular silicon particles can be produced in fluidized bed reactors by chemical vapor deposition (CVD). This process and related technologies are described in U.S. Patent Nos. 5,405,658; 5,322,670; 4,868,013; 4,851,297; and 4,820,587, the contents of which are each hereby incorporated by reference. In general, a particle bed comprising silicon seed particles is fluidized in a reactor and contacted with a thermally decomposable silicon deposition gas comprising a silicon-bearing compound at a temperature above the decomposition temperature of the compound. This results in deposition of silicon on the surfaces of the particles in the fluidized bed. It is often desirable for the silicon-bearing compound in the deposition gas to be silane (SiH₄), but it is also possible to use other silanes of the form SiₙH₍₂ₙ₊₂₎ (e.g., disilane) or halosilanes (e.g., chlorinated silanes). By continuing to contact the silicon particles with the silicon deposition gas, silicon continues to be deposited on the particles causing them to grow larger. Particles harvested from the reactor include a significant amount of silicon that has been deposited on the particles in the reactor. New seed particles can be supplied to the reactor to replace the harvested particles. The process can be substantially continuous. For example, some of particles (e.g., 15 percent of the particles) can be harvested periodically and new seeds can then be added, if necessary, to keep the total number of particles in the reactor within a desired range.

Decomposition of silicon from silane in a fluidized bed reactor can result in heterogeneous deposition (i.e., the silicon is deposited on a surface such as the surface of a seed particle) or homogeneous decomposition (i.e., the silicon decomposes as a new very small amorphous particle). Generally speaking, heterogeneous deposition is preferred. Homogeneous decomposition presents several problems. First, the amorphous particles produced by homogeneous decomposition, also known as fines, are very small (e.g., 10 microns or less). Because of their small size, the fines can easily be blown out of the fluidized bed and into the reactor exhaust system or otherwise lost. Under some operating conditions the production of fines cuts the process yield (i.e., the percentage of decomposable silicon in the silicon deposition gas that is converted to useful silicon particles) by 20 percent or more. Fines that do not get lost in the exhaust pose problems as well because they can coat the harvested silicon particles, which makes them dusty. Dusty silicon particles are dirty and difficult to handle. Moreover, when dusty silicon particles are poured into a crucible to be melted for use in a CZ crystal growing process, dust particles can temporarily adhere to parts of the crystal puller and later fall into the molten silicon, which causes defects in the growing silicon ingot.

Homogeneous decomposition is more likely to occur when operating conditions of the reactor provide more opportunity for decomposition to occur directly from the gas phase rather than while the deposition gas is interacting with the surface of a silicon particle. Thus, the extent of gas bubble bypassing, the volume fraction of gas bubbles in the fluidized bed, average size of gas bubbles in the fluidized bed, the velocity of gas bubbles through the fluidized bed, the total surface area of the particles in the fluidized bed, the concentration of the silicon-bearing compounds in the deposition gas, and a variety of other factors can affect the ratio of homogeneous decomposition to heterogeneous deposition.

It is generally desirable to increase the reactor throughput (i.e., the rate at which silicon is deposited on the seed particles) to reduce the manufacturing cost of granular silicon. Throughput can be increased by increasing the concentration of the silicon-bearing compound in the deposition gas. When the concentration of silane is above about 10 mole percent, for example, silicon is deposited on the surfaces of the particles at a significantly faster rate than when the silane concentration is about 5 mole percent or less. Unfortunately, increasing the silane concentration is also correlated with an undesirable increase the ratio of homogeneous decomposition to heterogeneous deposition. When the deposition gas contains about 12 mole percent silane, for example, 15 percent or more of the total silicon can be homogeneously decomposed. The result is that reactors operating in high throughput mode tend to produce a relatively dusty product and have a low yield because of lost silicon fines.

One approach to this problem is to operate a CVD fluidized bed reactor in a high-throughput mode for a period to rapidly deposit silicon on the particles and then reduce the concentration of the silicon-bearing compound in the deposition gas (e.g., to about 5 mole percent silane or less) to operate the reactor in a low-throughput mode for a specified time before removing any particles from the reactor. During the low-throughput mode of operation, the yield can be up to 95 percent. Further, heterogeneous silicon deposition during the low throughput phase tends to cement fines to the surfaces of the particles. Fines that are cemented to the surface of a particle are added to the silicon yield rather than being lost as waste. The amount of dust in the final product is also greatly reduced. The tradeoff is that throughput of the reactor is limited by the need to operate in low-throughput mode. It is often necessary to operate the reactor in low-throughput mode for more than 15 percent of its total operating time in order to achieve adequate dust reduction. Furthermore, some of the fines generated during the high-throughput mode are still wasted. Similarly, U.S. Patent No. 4,784,840 teaches that dusty silicon particles grown in a reactor operating in high-throughput mode can be transferred to another fluidized bed reactor that performs the cementing process by contacting the particles with a low concentration of silane gas. However, this is not entirely satisfactory because the second reactor limits the throughput of the system. It would be preferable to avoid making the investment in a second reactor that operates in a low-throughput mode. Also, the yield loss from fines produced in the high-throughput reactor is still an issue.

Purity of the granular silicon is another concern. Impurities in the granular silicon particles can contaminate the silicon melt and cause defects to be incorporated into the crystal ingot. A number of technologies have been used to reduce the impurities in granular silicon. For instance, U.S. Patent No. 4,871,524 is directed to a hydrogen purification process suitable for purifying hydrogen to remove boron and phosphorous. This purified hydrogen can be used as a carrier gas for the silicon-bearing compound to improve the purity of granular silicon produced in a fluidized bed reactor. Similarly, technology has been developed to purify silane gas for use in production of granular silicon particles. These efforts have been quite successful in enabling very pure silicon to be deposited on particles in a fluidized bed CVD reactor.

On the other hand, technology used to make silicon seeds lags behind in that seeds used to feed fluidized bed reactors are generally characterized by higher levels of contaminants than the silicon deposited by CVD reactors. It is difficult to make seeds without contaminating them because the seeds are typically produced by grinding, smashing or otherwise causing larger silicon particles to break into smaller seed-sized particles. This generally requires the seeds to contact surfaces that have been contaminated by metal. For example, one common method of producing silicon seed is disclosed in U.S. Patent No. 4,691,866, the contents of which are hereby incorporated by reference. The '866 patent is directed to a method of producing silicon seeds by striking a relatively large piece of silicon held in a container by a gun-target apparatus with a stream of 300 - 2000 micron silicon particles entrained in a high velocity gas stream to break the silicon into smaller seed particles. Experience shows that best commercial practices, such as the gun-target approach, typically produce seeds having transition metal concentrations (e.g., the sum of concentrations of Ni, Fe, and Cr) on the order of 5-10 ppba. Seed production is also wasteful because some granular silicon has to be consumed in seed production. About 30-40 percent of the silicon used for seed production is lost in the process.

Efforts to solve seed production problems have led the development of self-seeding CVD reactors. The idea of a self-seeding reactor is that the seed requirement of a fluidized bed reactor can be decreased by forming some of the silicon seeds inside the reactor. Some self-seeding naturally occurs inside fluidized bed reactors as some of the homogeneously deposited fines coalesce into particles that are large enough to avoid being blown into the exhaust system and that provide a large enough surface to accept silicon deposits. While this natural self-seeding may account for some of the seeds needed to keep the number of particles in the reactor within a desired operating range, it is not enough. Thus, various self-seeding reactors have been developed to increase the number of seeds produced inside a fluidized bed reactor. For example U.S. Patent No. 4,424,199, describes a fluidized bed reactor in which a high velocity gas jet acts on larger silicon particles collected in a boot separation chamber at the bottom of the reactor to comminute some of the larger silicon particles and produce new seed particles. Comminuting larger silicon particles in the reactor to make new seed particle is still wasteful because some of the new seed particles will be fines lost in the exhaust.

Another effort to solve seed production problems is disclosed in U.S. Patent No. 4,314,525, which is directed to a method of producing silicon seeds by decomposing a silicon deposition gas in a free space pyrolysis reactor. The free space reactor's homogeneously decomposed silicon fines are augmented by heterogeneous deposition in the free space reactor to form seed precursor particles ranging from 0.1 to about 5 microns. The seed precursor particles can be supplied to a small fluidized bed reactor which grows them into more appropriately sized seed particles of 50 microns or more. Use of a pyrolysis reactor to generate silicon seeds also presents some contamination concerns because hot gases are injected through the porous sidewall of the reactor to prevent the homogeneously decomposed particles from adhering to the sidewall. Materials that could be made porous to serve as the sidewall can contaminate the gas and introduce contaminants to the seeds.

### SUMMARY OF THE INVENTION

One aspect of the invention is a granular silicon composition generally comprises a plurality of free-flowing silicon particles having a total weight of at least about 300 kg. At least 99 percent of the particles are between about 250 and about 3500 microns in size.

Other objects and features of the present invention will be in part apparent and in part pointed out hereinafter.

### BRIEF DESCRIPTION OF THE DRAWINGS

Fig. 1 is a schematic cross section of a granular silicon particle having a seed formed in a fragmentation process;

Fig. 2 is a workflow diagram of a method of manufacturing granular silicon;

Fig. 3 is a schematic diagram of a three-reactor system suitable for production of granular silicon according to the present invention.

Corresponding reference characters indicate corresponding parts throughout the drawings.

### DETAILED DESCRIPTION

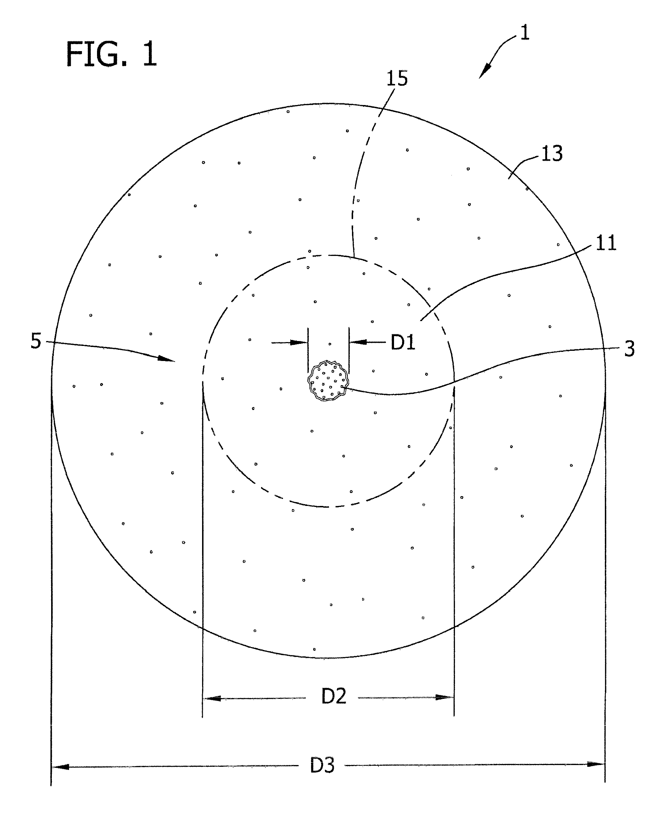

Granular silicon of the present invention is in the form of a plurality of free flowing silicon particles (granules). Some of the particles comprise seeds produced in a fragmentation process and other particles comprise seeds formed by coalescence of homogeneously decomposed particles inside a reactor. Referring to Fig. 1, for example, an exemplary granular silicon particle having a seed produced in fragmentation process, generally designated 1, comprises a relatively small silicon seed 3 surrounded by high purity silicon 5. The silicon 5 surrounding the seed particle 3 is high purity silicon that has been deposited on the seed particle by decomposition of a silicon-bearing compound as the seed is contacted by a silicon deposition gas (e.g., silane) in a pair of fluidized bed CVD reactors. The seed 3 is small piece of silicon formed by breaking a larger piece of silicon into a smaller seed sized particle (i.e., by a fragmentation process). For example, the seed 3 can suitably be formed by striking a target piece of silicon with a projectile piece of silicon, substantially as set forth in U.S. Patent No. 4,691,866. Thus, the seed 3 of the particle 1 shown in Fig. 1 is an externally-generated seed in that it was not produced by coalescence of homogeneously decomposed particles in a fluidized bed reactor.

Because of the well-known difficulties in breaking silicon particles down to seed sized particles without introducing contaminants, the seed 3 generally has a higher level of contamination than the surrounding silicon 5, at least initially. In particular, the seed has a higher concentration of transition metals (e.g., Ni, Fe, and Cr) than the surrounding silicon. The different contamination levels of the seed 3 and the surrounding silicon 5 is schematically indicated in Fig. 1 by the different density of speckling. Diffusion of contaminants from the seed 3 to the surrounding silicon 5 can alter the levels of contamination of the seed and the surrounding silicon over time, but this diffusion does not affect the overall contamination level of the particle 1 or of a granular silicon product comprising a plurality of such particles.

The granular silicon particle 1 shown in Fig. 1 is illustrated as having two layers 11, 13 of silicon surrounding the seed 3. Each layer 11, 13 was deposited on the seed 3 in a different fluidized bed reactor, as set forth in the manufacturing methods discussed below. It is possible to etch a particle to expose a cross section through the particle. In actual practice, etching a particle in this manner may reveal discernable growth rings 15, indicating the boundaries between the seed 3 and inner silicon layer 11 and/or between the inner 11 and outer 13 silicon layers. However, the growth rings 15 may be obscured or absent even though the particle comprises a seed 3 and layers 11, 13 of surrounding silicon 5. Thus, the presence of growth rings is a reliable indicator that a silicon particle was formed by separate silicon deposition procedures, but the absence of growth rings is not a reliable indicator that a particle was formed by a single silicon deposition procedure.

Those skilled in the art will recognize that granular silicon of the present invention will generally be handled, transported, sold, and used in the form of a large number of silicon particles. Further, the particles normally vary somewhat in size, shape, and structure. For example, some or all of the particles may be oblong or irregularly shaped rather than approximately spherical. The particles will not all be the same size. Instead, the particles will have a size distribution. Further, in contrast to the particle 1 shown in Fig. 1, particles formed from seeds generated inside the fluidized bed reactor typically have the same low contamination levels in the seed and the surrounding silicon. The granular silicon product will be made up of particles having both kinds of seeds. The purity of the granular silicon will be, essentially, a weighted average of the purity of the constituent particles.

One aspect of the present invention is that the ratio of the amount of silicon in the seeds generated by a fragmentation process to the total silicon in the granular silicon is lower than in conventional granular silicon products made from seeds formed by fragmentation. Thus, contamination attributable to the seeds formed by fragmentation is diluted by a larger amount of higher purity silicon. Preferably, the seeds formed by fragmentation account for no more than about 7 percent of the total mass of the granular silicon. More preferably, the seeds formed by fragmentation account for no more than about 5 percent of the total mass of the granular silicon. Still more preferably, the seeds formed by fragmentation account for no more than about 2 percent of the total mass of the granular silicon. Most preferably, the seeds formed by fragmentation account for between about 0.5 percent and about 1.5 percent of the total mass of the granular silicon.

Because the contamination attributable to the seeds produced by fragmentation is diluted by a larger amount of higher purity CVD silicon, the granular silicon of the present invention has higher purity than conventional granular silicon. Seeds produced by fragmentation are notorious for transition metal contamination. Thus, in one embodiment of the invention, the granular silicon contains less than 0.2 ppba transition metals (i.e., sum of Ni, Fe, and Cr). More preferably, the granular silicon contains between about 0.15 and about 0.1 ppba transition metals. Most preferably, the granular silicon contains no more than about 0.1 ppba transition metals. The iron content of the granular silicon is preferably less than about 0.13 ppba. More preferably, the iron content is between about 0.07 ppba and about 0.13 ppba. Most preferably, the iron content is between about 0.07 ppba and about 0.1 ppba. The granular silicon preferably also contains no more than about 0.1 ppba boron, no more than about 0.1 ppba phosphorous, no more than about 0.03 ppba other donor contaminants (e.g., arsenic and antimony), between about 0.02 and about 0.1 ppma carbon, and between about 0.3 and about 1.5 ppmw hydrogen. It is understood that the granular silicon may have higher concentrations of one or more of the aforementioned contaminants without departing from the scope of the present invention. In another embodiment, between about 0.01 and about 0.02 percent of the weight of the granular silicon is attributable to surface dust. More preferably, between about 0.006 and 0.02 percent of the weight of the granular silicon is attributable to surface dust. As used herein, the term surface dust refers to material adhering to the surfaces of the particles that can be removed by liquid washing.

It is desirable for the particles to be suitably sized for use in a CZ crystal puller. Size of the particles is also important because operation of a fluidized bed reactor being supplied with seeds below a certain size (e.g., 50 microns) is impractical and inefficient. However, larger seeds produced in a fragmentation process introduce more contaminants. As noted above, the particles normally vary somewhat in size and other characteristics. Therefore, particle size is specified as an average. Thus, the silicon particles of the granular silicon preferably have an average size between about 800 and 1200 microns. More preferably, the particles have an average size between about 900 and 1100 microns. Most preferably, the particles have an average size between about 950 and 1050 microns. Preferably, at least 99% of the particles range in size from about 250 to about 3500 microns and less than about 0.5 percent of the total weight of the granular silicon is attributable to silicon particles that are less than about 300 microns in size. The seeds generated by a fragmentation process have an average size less than about 150 microns. Preferably, the seeds generated by a fragmentation process have an average size between about 50 and 150 microns. More preferably, the seeds generated by a fragmentation process have an average size between about 75 microns and about 125 microns. Most preferably, the average size of the seeds generated by a fragmentation process is about 100 microns.

The granular silicon of the present invention can also be produced in commercially relevant quantities using the methods described below. For instance, consistent with current industry practice for conventional granular silicon, quantities of granular silicon of the present invention weighing about 300 kg can be packaged (e.g., in a drum) for transportation. Also consistent with current industry practice for conventional granular silicon, quantities of granular silicon of the present invention weighing about one metric ton can be sold as one unit.

The granular silicon of the present invention can be used in virtually the same manner as ordinary granular silicon. Because of the low level of contamination, however, the granular silicon contributes fewer contaminants to silicon products (e.g., semiconductor material) made with the granular silicon than would be contributed by conventional granular silicon. This facilitates production of silicon products having higher purity and fewer defects. The relatively uniform size distribution and low dust content of the granular silicon also makes it easier to handle, and facilitates charging and recharging of crucibles with the granular silicon.

Granular silicon of the present invention can posses one, all, or virtually any combination of the characteristics discussed above without departing from the scope of this invention. It is sometimes particularly desirable for granular silicon to deviate from one or more of the characteristics discussed above. For instance, the silicon can be intentionally doped with a p or n type carrier (e.g., boron) as suggested in U.S. Patent No. 4,789,596 without departing from the scope of this invention. Those skilled in the art will recognize that, for any of numerous other reasons, it is possible or even desirable to relax or deviate from one or more of the characteristics listed above without departing from the scope of this invention.

### Manufacturing Process

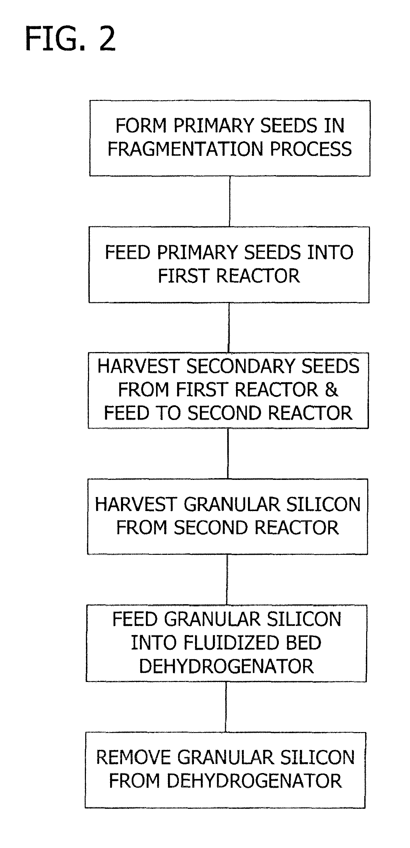

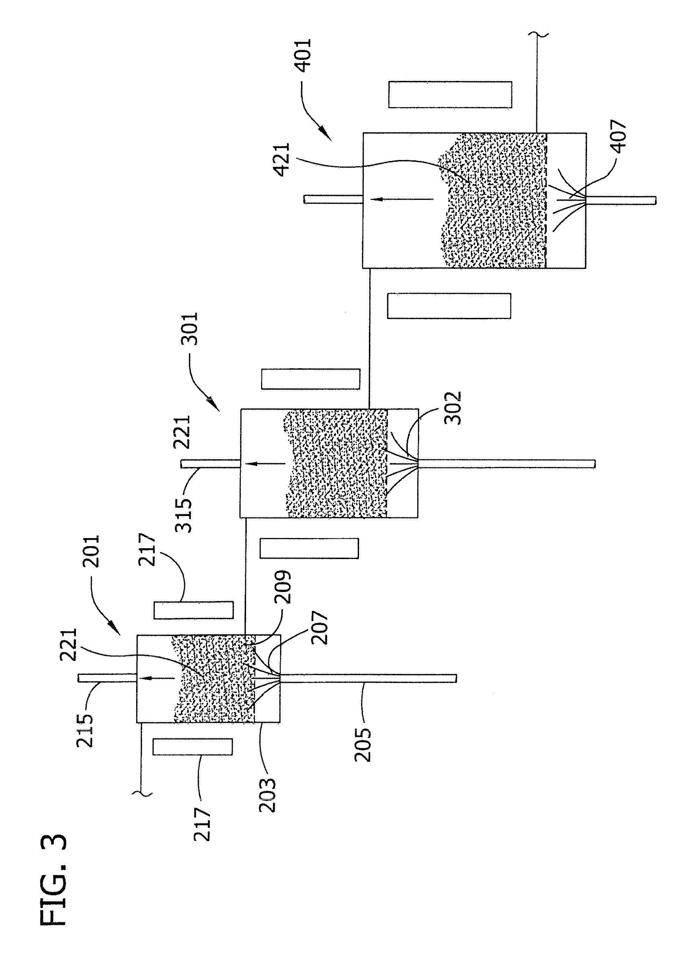

Referring to Figs. 2 and 3, a manufacturing method of the present invention includes the following basic steps. First, as shown in Fig. 2, primary silicon seeds are produced by breaking larger silicon particles into seed sized silicon particles of a first average size. Then the primary seeds are fed to a first fluidized bed reactor where they are grown into intermediate-sized secondary seeds of a second average size by thermal decomposition of a silicon-bearing compound in the first reactor. The secondary seeds are fed into a second fluidized bed reactor where they are grown into granular silicon particles of a third average size by thermal decomposition of a silicon-bearing compound in the second reactor. Then the granular silicon is fed into a dehydrogenator that reduces the hydrogen content of the silicon particles and eliminates some of the surface dust adhering to the granular particles. Each of these steps will be discussed in more detail below.

The primary seeds are produced by breaking larger silicon pieces into smaller particles, including the seed-sized particles of the first average size. The primary seeds produced in this step are essentially the same as ordinary silicon seeds except that the primary seeds are made somewhat smaller than the seeds that would ordinarily be used. Thus, in one embodiment the primary seeds that are fed into the first reactor have a first average size of less than about 150 microns. Preferably, the primary seeds have a first average size between about 50 and about 150 microns. More preferably, the primary seeds have a first average size between about 75 and 125 microns. Most preferably, the primary seeds have a first average size of about 100 microns. Also, in the present embodiment, about 90 percent of the primary seeds are between about 10 microns and about 300 microns.

The primary seeds can be formed by crushing, grinding, milling or any other process for breaking silicon particles into smaller particles. One particularly desirable way to produce silicon seeds is to strike a silicon target with a stream silicon particles (e.g., 300 - 2000 micron particles) substantially as described in U.S. Patent No. 4,691,866. The resulting silicon fragments are sorted by size to separate particles that are suitable for use as seeds from other particles. For example, the particle classifier shown in U.S. Patent No. 4,857,173, which is hereby incorporated by reference, may be used to sort silicon fragments according to size to obtain a supply of suitably sized seeds. It is desirable to produce primary seeds having as little contamination as possible, but the seeds will usually have a transition metal concentration of about 5-10 ppba. Advances in seed production technology may allow seeds having lower contamination levels than can presently be obtained to be used in the future without departing from the scope of this invention. Moreover, the methods disclosed herein can be used to produce a high-purity granular silicon product whenever silicon seeds have contamination levels exceeding the contamination levels that can be achieved for silicon deposited in a CVD reactor.

Referring to Fig. 3, the primary seeds are fed into the first fluidized bed (chemical vapor deposition) reactor 201. The configuration of the reactor is not critical to the invention, but the basic design and operation of the exemplary reactor shown in Fig. 3 will be described for illustrative purposes. The reactor comprises a generally cylindrical vessel 203. A gas inlet 205 is provided at the bottom of the reactor 201 for supplying a fluidizing gas 207 to a distributor plate 209 in the lower part of the vessel 203. An exhaust outlet 215 is provided at the top of the reactor 201 to allow gas to be vented from the vessel 203 to an exhaust system (not shown). A heater 217 is provided to heat the vessel and its contents. The heater can be any of a variety of heaters, such as electrical resistance heaters, electromagnetic heaters, magnetic induction heaters, or any combination thereof.

Operation of the reactor 201 involves forming a heated particle bed 221 comprising the primary silicon seeds in the vessel 203 above the distributor plate 209. The particle bed 221 may be entirely made of primary seeds, but it will typically be a combination of primary seeds, previously added primary seeds that are already in the process of growing into secondary seeds, and some particles that have grown from homogeneously decomposed particles. The particle bed 221 is fluidized by flowing a stream of heated gas 207 up through the gas inlet 205 and distributor plate 209. In the exemplary embodiment, for example, the gas 207 used to fluidized the particle bed 221 is mixture of a carrier gas (e.g., hydrogen) and a silicon deposition gas (e.g., silane). Thus, the particles in the fluidized bed 221 are contacted with the silicon deposition gas. Further, the silicon-bearing compound in the gas 207 decomposes because of the heat provided by the heater 217 and stored in the heated gas 207, the silicon particles 221, and the structures of the reactor 201. For example, the temperature inside the reactor 201 may be between about 1100 EF and about 1300 EF. This causes silicon to be deposited on the surfaces of the particles 221.

One aspect of the invention is that the first fluidized bed reactor 201 operates substantially continuously in high-throughput mode. For example, the particles may be contacted with a gas comprising at least about 9 mole percent silane. Preferably, the particles are contacted with a gas comprising more than about 14 mole percent silane. More preferably, the particles are contacted with a gas comprising between about 16 and 24 mole percent silane. Most preferably, the particles are contacted with a gas comprising between about 18 and 20 mole percent silane. Preferably, a mixture of silane and carrier gas having the specified concentration of silane is introduced to the reactor at the inlet 205 as shown in Fig. 3. However, it is understood that silane and the carrier gas can also be introduced to the reactor separately, in the appropriate amounts, and mixed in the reactor without departing from the scope of the present invention. In the present embodiment, the reactor 201 is operated with an internal pressure between about 5 and about 15 psig. However, the internal pressure can range from subatmospheric to several atmospheres without departing from the scope of this invention.

The secondary seed particles are periodically or substantially continuously harvested from the first reactor 201 in any manner known to those skilled in the art. For example, a portion (e.g., 15 percent) of the particles can be harvested periodically (e.g., about every four hours). Additional primary seeds are periodically or substantially continuously fed to the reactor to keep the total number of particles in the reactor within a desired range. Because the particle bed is thoroughly mixed by the fluidization process, some of the secondary seeds harvested from the first reactor will have spent more time in the first reactor and grown larger than others. The secondary seeds harvested from the first reactor have a second average size larger than the first average size of the primary seeds. In the present embodiment of the invention, the secondary seeds harvested from the first reactor have an average size of at least about 250 microns. More preferably, the average size of the secondary seeds is between about 250 microns to about 600 microns. Most preferably, the secondary seeds have an average size between about 400 and about 500 microns.

The amount of particle growth for a fluidized bed reactor is commonly expressed as a growth ratio, which is the ratio of the mass of the seeds added to the reactor to the mass of the harvested silicon particles. The growth ratio of the first reactor 201 is between about 13 and about 20. That range of growth factor indicates between about 1 /13 and about 1 / 20 of the mass of the secondary seeds is attributable to the primary seeds. The rest of the mass is attributable to decomposition of the silicon deposition gas and has a higher purity than the primary seeds. The growth ratio of the first reactor 201 is augmented by production of additional seeds formed by coalescence of homogeneously decomposed particles in the first reactor, as discussed in more detail below.

The secondary seeds are fed into the second fluidized bed (chemical vapor deposition) reactor 301, where they are grown into larger granular silicon particles. As was the case with the first reactor 201, the configuration of the second reactor 301 is not critical to the invention. In one embodiment, (shown Fig. 3) the basic design and operation of the second reactor 301 is substantially similar to the first reactor except as noted herein.

Like the first reactor 201, the second reactor 301 is operated substantially continuously in high-throughput mode. The particles 321 in the second reactor 301 are contacted with a gas 307 comprising at least 7 mole percent silane. Preferably, the particles 321 in the second reactor 301 are contacted with a gas 307 having a silane concentration greater than about 7 mole percent and less than the silane concentration of the gas 207 used to contact the particles 221 in the first reactor 201. More preferably, the particles 321 in the second reactor 301 are contacted with a gas 307 having a silane concentration between about 7 and about 13 mole percent.

The secondary seeds grow into larger granular silicon particles, which are periodically or substantially continuously harvested from the second reactor 301 in a manner similar to the way particles are harvested from the first reactor 201. Preferably, the granular silicon particles harvested from the second reactor 301 have a third average size between about 800 and about 1200 microns. More preferably, the granular silicon particles harvested from the second reactor 301 have an average size between about 900 and about 1100 microns. Most preferably, the granular silicon particles harvested from the second reactor 301 have an average size between about 950 and about 1050 microns.

The growth ratio of the second reactor 301 is between about 5 and about 10. The combined growth ratio of the first 201 and second 301 reactors together (i.e., the ratio of the mass of the primary seeds fed to the first reactor 201 to the mass of the granular silicon particles harvested from the second reactor 301) is between about 65 and about 200. More preferably, the combined growth ratio of the first 201 and second 301 reactors is between about 90 and 150.

One aspect of the invention is that the operation of the first 201 and second 301 fluidized bed reactors is influenced by the difference in the average particle size of the particles in the first 221 and second 321 fluidized beds. As those skilled in the art know, average particle size influences a number of other characteristics of a fluidized bed. For example, for any given ratio of fluidizing gas velocity (U) to the minimum gas velocity capable of fluidizing the bed (U_{mf}), bubble bypassing is greater when the average particle size is smaller. An increase in bubble bypassing favors homogeneous decomposition.

The average particle size of the particles in the first reactor 201 is smaller than the average particle size in an ordinary silicon producing CVD fluidized bed reactor. It is also smaller than the average particle size of particles in the second reactor 301. Conversely, the average size of the particles in the second reactor 301 is larger than would be found in a typical silicon producing CVD fluidized bed reactor. For example, in one embodiment the average particle size in the first reactor 201 is between about 300 and 600 microns and the average particle size in the second reactor is between about 800 and 1200 microns.

The smaller average particle size of particles in the first reactor 201 is more favorable for homogeneous decomposition and results in a lower U_{mf} for the first reactor. Conversely, U_{mf} for the second reactor 301 is higher than it is for ordinary silicon producing fluidized bed reactors because of the larger average particle size in the second reactor. Preferably, the ratio of U/U_{mf} for the first reactor 201 is between 1 and about 5 and the ratio of U/U_{mf} for the second reactor 301 is between 1 and about 3. More preferably, the ratio of U/U_{mf} for the first reactor 201 is between about 2 and about 4 and the ratio of U/U_{mf} for the second reactor 301 is between 1 and about 2. Although the ranges for U/U_{mf} of the first 201 and second 301 reactors overlap, the gas velocity for the second reactor is higher than the gas velocity for the first reactor because of the influence of average particle size on the value of U_{mf}.

Because of its relatively lower U_{mf}, the first reactor 201 can be operated with a lower gas velocity than the velocities ordinarily used for production of silicon in a fluidized bed reactor. This allows a comparatively larger fraction of the homogeneously decomposed fines to remain in the fluidized bed 221 of the first reactor 201 rather than being blown out through the exhaust outlet 215 into the exhaust system. Accordingly, the first reactor 201 experiences an increase in the amount of self-seeding because some of the homogeneously decomposed fines that would normally be lost in the exhaust coalesce inside the reactor to form internally-generated seeds that then grow into secondary seeds. The increase in the fraction of homogeneously decomposed particles that coalesce to form seeds in the first reactor 201 also reduces the seed requirement for the process, thereby improving efficiency. The benefits of the self-seeding make it economical to increase the concentration of silane above 14 mole percent to increase the throughput of the first reactor 201 and generate homogeneously decomposed particles for partially self-seeding the first reactor.

Preferably, the silane concentration is lower in the second reactor 301 than the first reactor 201, which also favors heterogeneous decomposition. Because the larger average particle size results in a higher U_{mf} for the second particle bed 231, the particles in the second reactor 301 are fluidized by flowing gas 307 upwardly through the reactor at a rate higher than is used in the first reactor 201. Small dust sized particles in the second reactor 301 are more likely to be blown out of the fluidized bed through the exhaust outlet 315 because of the relatively higher gas velocity. This does reduce the amount of self-seeding in the second reactor 301, but this is more than offset by the increase in the ratio of heterogeneous to homogeneous decomposition caused by the larger average particle size in the second reactor 301. Moreover, the higher gas velocity in the second reactor 301 translates to more silicon deposition gas being passed through the particle bed 321 in a given amount of time for a given concentration, thereby increasing the throughput of the second reactor 301.

The granular silicon harvested from the second reactor 301 can be used as is without departing from the scope of the invention. If the granular silicon is to be used for recharge of a crucible in a CZ crystal puller, however, it will be desirable to reduce the hydrogen content of the granular silicon. It may also be desirable to further reduce the dust content of the granular silicon harvested from the second reactor 301. Both hydrogen and dust reduction can be achieved by feeding the granular silicon particles from the second reactor 301 into a fluidized bed dehydrogenator 401. For example, the granular silicon particles harvested from the second reactor 301 can be fed into the fluidized bed dehydrogenator described in U.S. Patent No. 5,326,547, which is hereby incorporated by reference. Basically, the dehydrogenator 401 operates by fluidizing a bed of silicon particles 421 with an inert gas 407 (e.g., hydrogen) at temperatures higher than the temperatures encountered in CVD fluidized bed reactors for decomposition of silicon-bearing compounds. Hydrogen diffuses out of the particles over time at this higher temperature. Thus, in one embodiment of the present invention granular silicon harvested from the second reactor 301 is fed into a fluidized bed dehydrogenator 401 and held between about 1800 and about 2200 EF for a period of time sufficient to reduce the hydrogen content of the granular silicon to about 0.3 to about 1.5 ppmw. This step also reduces the dust content of the granular silicon. For example, granular silicon particles harvested from the second reactor 301 can have a surface dust content of about 0.1 to about 0.4 weight percent. The dehydrogenation process can reduce the surface dust content to between about 0.01 and about 0.02 weight percent. More preferably, the dehydrogenation process can reduce the surface dust content to between about 0.01 and about 0.006 weight percent. Preferably, the dehydrogenation process reduces the dust content by at least about 80 percent. More preferably, the dust content is reduced by at least about 95 percent. Most preferably, the dust content is reduced by at least about 98 percent.

The methods of the present invention provide advantages from the standpoint of product purity. They also provide a number of advantages from an efficiency standpoint. By combining the first and second fluidized bed reactors in the manner described, the yield can be increased about 2-5 percent over the best conventional practices. At the same time, the throughput can be increased about 15-20 percent over the best conventional practices. Throughput can be measured in terms of the ratio of the rate of silicon production to the size of the reactor vessel (expressed in terms of the average cross sectional area of the reactor). Preferably the throughput through the second reactor is at least about 140 kg/h per m². In the embodiment described herein, the throughput of the second reactor is between about 140 kg/h per m² and about 155 kg/h per m². The methods result in a significant reduction in the concentration of transition metals in comparison to the best conventional practices for producing granular silicon. In general, it is anticipated that those practicing the inventive methods will want to take advantage all the advantages listed above and/or discussed elsewhere herein, but it is possible for skilled artisans to use the teachings herein to obtain the benefits of fewer than all the advantages, if that suits them, without departing from the scope of this invention.

Further, a variety of fluidized bed reactor designs have been used to grow granular silicon from silicon seeds. Those skilled in the art will be able to adapt virtually any fluidized bed reactor suitable for conventional production of granular silicon for use according to the present invention. For example, there is great flexibility in the manner in which gases are flowed into the reactors. Silicon deposition gas (e.g., silane) can be introduced separately from the carrier (e.g., hydrogen). Some prefer to do this because it can facilitate keeping the silicon deposition gas below the decomposition temperature until it is heated by the heat from the particles, which can reduce the buildup of silicon deposits on the gas inlet. The silicon deposition gas can be introduced to the reactor at a different location from the fluidizing gas or even through a plurality of inlets at various location in the reactor, to name just a few of the countless variations that are possible.

When introducing elements of the present invention or the preferred embodiments thereof, the articles "a", "an", "the", and "said" are intended to mean that there are one or more of the elements. The terms "comprising", "including", and "having" are intended to be inclusive and mean that there may be additional elements other than the listed elements.

As various changes could be made in the above compositions, products, and methods without departing from the scope of the invention, it is intended that all matter contained in the above description and shown in the accompanying drawings shall be interpreted as illustrative and not in a limiting sense.

## Claims

1. A granular silicon composition comprising a plurality of free-flowing silicon particles having a total weight of at least about 300 kg, wherein at least 99 percent of the particles are between about 250 and about 3500 microns in size.

2. The granular silicon composition of claim 1 wherein the total weight of the particles is at least one metric ton.

3. The composition of any preceding claim wherein the particles have an average transition metal concentration of no more than about 0.1 ppba.

4. The composition of any preceding claim wherein the particles have an average boron concentration of no more than about 0.1 ppba.

5. The composition of any preceding claim wherein the particles have an average phosphorous concentration of no more than about 0.1 ppba.

6. The composition of any preceding claim wherein the particles have an average carbon concentration between about 0.02 and about 0.1 ppma.

7. The composition of any preceding claim wherein the particles have an average hydrogen concentration between about 0.3 and about 1.5 ppmw.

8. The composition of any preceding claim wherein the particles have an average size between about 800 and about 1200 microns.

9. The composition of any preceding claim wherein between about 0.006 and about 0.02 percent of the weight is attributable to surface dust.
